# FASCICULE DE BREVET EUROPEEN

(11) **EP 0 820 151 B1**
(45) Date de publication et mention de la délivrance du brevet: **21.05.2003**
(21) Numéro de dépôt: 97401588.5
(22) Date de dépôt: 03.07.1997
(51) Int. Cl.: H03M 7/42

(54) **Procédé et dispositif de compression et de décompression de messages**
Verfahren und Vorrichtung zur Komprimierung und Dekomprimierung von Botschaften
Method and device for compression and decompression of messages

(30) Priorité: 16.07.1996 FR 9608857
(43) Date de publication de la demande: 21.01.1998
(73) Titulaire: ALCATEL, 75382 Paris Cédex 08 (FR)
(72) Inventeur: Martin, Jean-Marie, 92600 Asnieres Sur Seine (FR)
(74) Mandataire: El Manouni, Josiane

(56) Documents cités:
- EP-A- 0 083 393
- EP-A- 0 280 549
- US-A- 4 955 066
- YEHESKEL BAR-NESS ET AL: "WORD BASED DATA COMPRESSION SCHEMES 1" 8 mai 1989 , PROCEEDINGS OF THE INTERNATIONAL SYMPOSIUM ON CIRCUITS AND SYSTEMS, PORTLAND, MAY 8 - 11, 1989, VOL. 1 OF 3, PAGE(S) 300 - 303 , INSTITUTE OF ELECTRICAL AND ELECTRONICS ENGINEERS XP000131243 * page 301, colonne de gauche, ligne 35 - colonne de droite, ligne 14 *

## Description

La présente invention concerne d'une manière générale la compression de données.

La présente invention est plus particulièrement applicable à la compression de messages destinés à être affichés sur l'écran d'un appareil tel qu'un terminal de télécommunications, notamment un téléphone portable, ces messages étant formés de mots formés eux-mêmes de caractères, ces caractères étant eux-mêmes codés, pour leur stockage dans des moyens de traitement de données internes à cet appareil, selon un code binaire tel que le code ASCII par exemple.Dans une telle application, la compression de messages permet essentiellement de réduire la taille de mémoire nécessaire au stockage de ces messages, et donc de réduire la taille des circuits internes à un tel appareil.

Diverses méthodes de compression de données sont connues et décrites par exemple dans le livre intitulé "Compression de données - Méthodes, algorithmes, programmes détaillés" (Pascal PLUME - Editions Eyrolles).

Parmi ces méthodes on peut citer la méthode dite de HUFFMAN qui opère sur des caractères et qui consiste à coder sur une longueur binaire relativement courte (par rapport à un codage binaire classique tel que par exemple le codage ASCII) des caractères qui ont une occurrence relativement élevée, et au contraire sur une longueur binaire plus élevée des caractéres qui ont une occurrence plus faible, la table de codage ainsi obtenue étant transmise au dispositif destiné à effectuer l'opération inverse de décompression.

Une telle méthode n'est pas adaptée à la compression de messages, notamment en termes de taux de compression, compte tenu du fait que lesdits mots ou lesdits messages comportent la plupart du temps des séquences répétitives de caractères.

Une amélioration de cette méthode est décrite par la demande de brevet européen EP 0280549 qui décrit un mécanisme basé sur deux tables de codage, la première est un dictionnaire qui fait correspondre des mots usuels à des codes compressés. Si le mot à compresser est dans ce dictionnaire, alors son code compressé est utilisé, sinon le mot est compressé, caractère par caractère, par exemple en utilisant la méthode d'Huffman.

Bien qu'améliorant ce dernier, ce procédé n'est pas non plus optimal en ce qui concerne le taux de compression.

Pour éviter cet inconvénient on peut utiliser une méthode telle que la méthode dite de LEMPEL-ZIV-WELCH qui permet de compresser de telles séquences répétitives de caractères en les remplaçant par leur rang dans une table de codage appelée dictionnaire, créée dynamiquement au fur et à mesure de la lecture du texte à compresser, et recréée de façon similaire au moment de la décompression. Une telle méthode, connue aussi sous l'expression anglo-saxonne de "on line textual substitution",présente un meilleur taux de compression que la méthode citée précédemment. Elle a cependant pour principal inconvénient de nécessiter un temps de décompression relativement long.

Un besoin particulier existe donc pour la compression de messages, notamment de messages en nombre relativement important, de taille relativement courte, et utilisant un vocabulaire relativement restreint, tels que par exemple des messages destinés à être affichés sur l'écran d'un appareil tel qu'un terminal de télécommunications, notamment un téléphone portable, ce besoin consistant notamment en une méthode qui soit suffisamment performante en temps de décompression, tout en restant suffisamment économique en termes de taux de compression.

La présente invention a ainsi pour objet un procédé de compression de messages selon la revendication 1,

La présente invention a également pour objet un procédé correspondant de décompression de messages selon la revendication 7.

La présente invention a également pour objet un dispositif correspondant de décompression de messages selon le revendication 10.

D'autres objets et caractéristiques de la présente invention apparaîtront à la lecture de la description suivante d'un exemple de réalisation, faite en relation avec les dessins ci-annexés dans lesquels:
- la figure 1 est un organigramme destiné à illustrer les différentes étapes d'un exemple de réalisation d'un procédé de compression suivant l'invention,
- la figure 2 est un organigramme destiné à illustrer les différentes étapes d'un exemple de réalisation d'un procédé de décompression correspondant,
- la figure 3 illustre schématiquement un exemple de réalisation d'un dispositif de décompression correspondant.

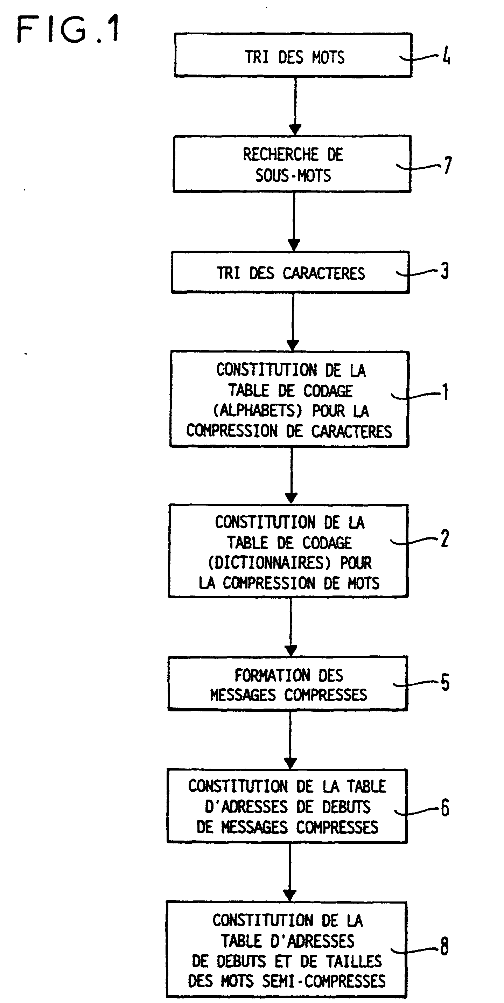

Le procédé de compression illustré sur la figure 1 comporte des étapes, notées repectivement 1 et 2, de constitution de tables de codage appelées respectivement table de codage pour la compression de mots et table de codage pour la compression de caractères, dans lesquelles sont rangés respectivement, sous forme codée, les mots constitutifs des messages considérés, et les caractères constitutifs de ces mots, chaque caractère ou mot étant défini par son rang de classement dans une telle table, et ce rang de classement, une fois codé,en l'occurrence en binaire, représentant la forme compressée de ce mot ou de ce caractère.

Une table de codage pour la compression de caractéres contient en l'occurrence des caractères sous une forme non compressée, par exemple selon un code binaire tel que le code ASCII.

Une table de codage pour la compression de mots contient en l'occurrence des mots sous une forme dite semi-compressée, un mot semi-compressé étant constitué par une séquence de caractères compressés correspondant aux caractères successifs formant ce mot.

Dans l'exemple illustré, il est en outre préalablement prévu des étapes, repectivement 3 et 4, de tri des caractères et des mots par fréquence d'apparition dans lesdits mots et dans lesdits messages, et lesdites tables de codage comportent elle-mêmes plusieurs tables appelées respectivement alphabets et dictionnaires, les caractères (respectivement les mots) les plus fréquemment utilisés étant destinés à être rangés dans un alphabet (respectivement un dictionnaire) de plus petite taille, c'est-à-dire dont les rangs peuvent être codés au moyen de moins de bits.

L'étape 1 de constitution des alphabets consiste alors par exemple à ranger les 8 caractères les plus utilisés dans un premier alphabet dont les rangs sont codés en binaire au moyen de 3 bits, et les autres caractères, par exemple au nombre de 128, dans un deuxième alphabet dont les rangs sont codés en binaire au moyen de 7 bits.

L'étape 2 de constitution des dictionnaires consiste alors par exemple à ranger les 8 mots les plus utilisés dans un premier dictionnaire dont les rangs sont codés en binaire au moyen de 3 bits, les 64 mots suivants (par ordre de fréquence d'utilisation décroissante) dans un deuxième dictionnaire dont les rangs sont codés en binaire au moyen de 6 bits, et les autres mots, par exemple au nombre de 1024, dans un troisième dictionnaire dont les rangs sont codés en binaire au moyen de 10 bits.

Le code binaire indiquant le rang dans un alphabet ou dans un dictionnaire est alors précédé d'un code destiné à indiquer duquel de ces alphabets, ou de ces dictionnaires, il s'agit.Dans l'exemple considéré, le numéro d'alphabet peut ainsi être indiqué au moyen d'un code binaire à un seul élément binaire, et le numéro de dictionnaire au moyen d'un code binaire à deux éléments binaires.

En outre, les espaces séparateurs de mots dans lesdits messages sont considérés comme des mots pour la mise en oeuvre de ce procédé, ce qui permet d'optimiser le taux de compression.

La formation d'un message compressé (étape 5) est alors obtenue en remplaçant chaque mot constitutif de ce message par le mot compressé correspondant, à savoir le code binaire du rang de ce mot dans le dictionnaire correspondant, étant entendu que le contenu dudit dictionnaire audit rang est lui-même formé par le mot dit semi-compressé constitué par la séquence des codes binaires des rangs, dans lesdits alphabets, des caractères constitutifs de ce mot.

En outre, dans l'exemple considéré, les messages compressés étant destinés à être stockés de manière contiguë dans une mémoire prévue dans le dispositif chargé d'effectuer l'opération inverse de décompression, et ces messages ayant une taille variable, il est nécessaire de prévoir un mécanisme permettant de déterminer le début et la fin de chaque message compressé dans ladite mémoire.Dans l'exemple considéré, ce mécanisme comporte une étape 6 de constitution d'une table dite table d'adresses de débuts de messages compressés, destinée à indiquer les adresses de début desdits messages compressés dans ladite mémoire.

De même, les mots semi-compressés étant, dans l'exemple considéré, destinés à être stockés de maniére contiguë dans cette mémoire, et la taille de ces mots semi-compresses étant variable, il est nécessaire de prévoir un mécanisme permettant de déterminer le début et la fin de chaque mot semi-compressé dans ladite mémoire.

Par ailleurs, dans l'exemple considéré, afin d'optimiser encore le taux de compression, le procédé de compression comporte en outre une étape notée 7 de recherche d'inclusion de mots, appelés sous-mots, au sein de mots plus grands appelés mots racines.Seuls les mots racines sont rangés dans les dictionnaires, la numérotation des rangs dans ces dictionnaires étant alors modifiée de manière à définir également des rangs pour ces sous-mots, et ledit mécanisme permettant de déterminer le début et la fin de chaque mot semi-compressé dans ladite mémoire devant alors permettre de déterminer le début et la fin de chaque mot semi-compressé, qu'il s'agisse d'un mot racine ou d'un sous-mot.

Dans l'exemple considéré , ce dernier mécanisme comporte une étape 8 de constitution d'une table dite table d'adresses de débuts de mots semi-compressés, destinée à indiquer les adresses de début de ces mots (qu'il s'agisse de mots racines ou de sous-mots) dans ladite mémoire, et d'une table dite table de tailles de mots semi-compressés, destinée à indiquer la taille de ces mots (qu'il s'agisse de mots racines ou de sous mots)dans ladite mémoire.

Il est en outre prévu une telle table d'adresses de débuts de mots semi-compressés et une telle table de tailles de mots semi-compressés pour chacun desdits premier, deuxième, et troisième dictionnaire.

En outre, dans l'exemple considéré, les étapes 3 de tri des caractères et 1 de constitution des alphabets sont avantageusement prévues après les étapes 4 (tri des mots) et 7 (recherche de sous-mots), afin de n'effectuer un tri des caractères que sur les mots racines.

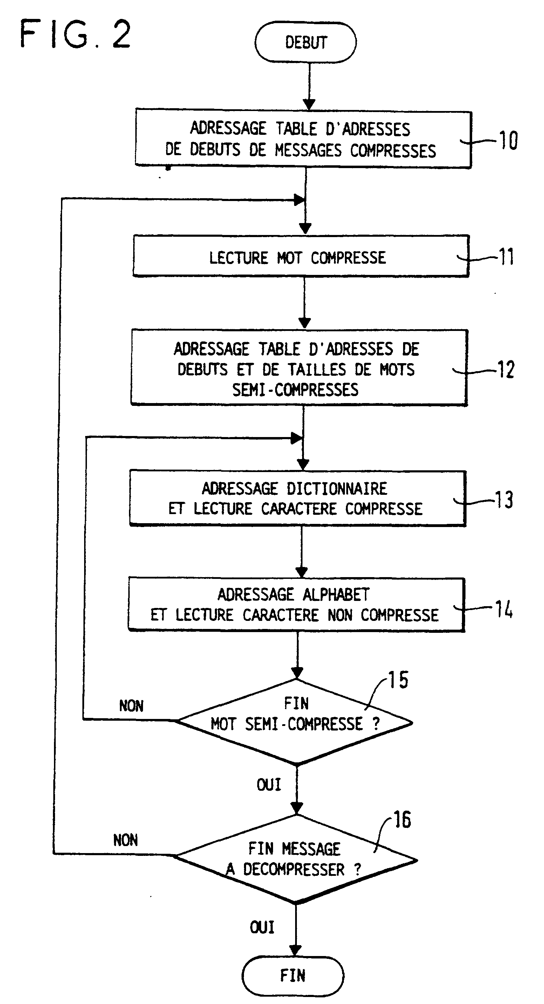

Un exemple de procédé de décompression correspondant est illustré sur la figure 2.

Au cours d'une première étape de ce procédé, notée 10, on lit la table d'adresses de débuts de messages compressés à une adresse déterminée à partir d'une information (supposée fournie) identifiant le message à décompresser, ainsi qu'à une adresse correspondant au message compressé situé de manière contiguë en mémoire.

Au cours d'une deuxième étape, notée 11, on lit, à l'adresse de début de message compressé ainsi obtenue, le mot compressé correspondant au premier mot du message à décompresser.

Le résultat de cette nouvelle lecture permet, au cours d'une troisième étape, notée 12, d'adresser d'une part la table d'adresses de débuts de mots semi-compressés, pour obtenir l'adresse de début du mot semi-compressé correspondant au premier mot du message à décompresser, et d'autre part la table de tailles de mots semi-compressés, pour obtenir la taille de ce mot semi-compressé.

L'obtention de l'adresse de début de ce mot semi-compressé permet ainsi, au cours d'une quatrième étape, notée 13, d'adresser le dictionnaire correspondant, et d'obtenir ainsi le premier caractère compressé constitutif de ce mot.

La lecture de ce premier caractère compressé permet à son tour, au cours d'une cinquième étape, notée 14, d'adresser l'alphabet correspondant, et d'obtenir ainsi le premier caractère non compressé correspondant, qui peut alors être transmis vers un registre destiné à stocker le message décompressé à afficher (étape 15).

L'adresse courante est alors remplacée par l'adresse du caractère compressé suivant du mot semi-compressé considéré, et tant que cette adresse courante reste inférieure à la somme de l'adresse de début du mot semi-compressé considéré et de la taille de ce mot semi-compressé (ce qui correspond à l'étape de test notée 16), ce procédé de lecture des caractères non compressés constitutifs du mot considéré se poursuit, les caractères non compressés ainsi obtenus étant transmis vers ledit registre destiné à stocker le message décompressé à afficher.

Lorsque l'adresse courante devient supérieure à la somme de l'adresse de début du mot semi-compressé considéré et de la taille de ce mot semi-compressé, on passe au mot semi-compressé suivant, et ainsi de suite tant que l'adresse à l'intérieur de la zone des messages compressés reste inférieure à l'adresse de début du message compressé stocké de manière contiguë en mémoire (ce qui correspond à l'étape de test notée 17).

Dans cette description, il a été supposé qu'à chaque adresse considérée de la mémoire était stocké le nombre exact d'éléments binaires correspondant à l'information recherchée (qu'il s'agisse d'une adresse de début de message compressé, d'un mot compressé, d'une adresse de début de mot semi-compressé, d'une taille de mot semi-compressé, d'un caractère non compressé, ou d'un caractère compressé).Les adaptations à apporter, le cas échéant, relèveraient cependant simplement des techniques, classiques pour l'homme du métier, et donc non redécrites ici, d'organisation et d'adressage d'une mémoire.

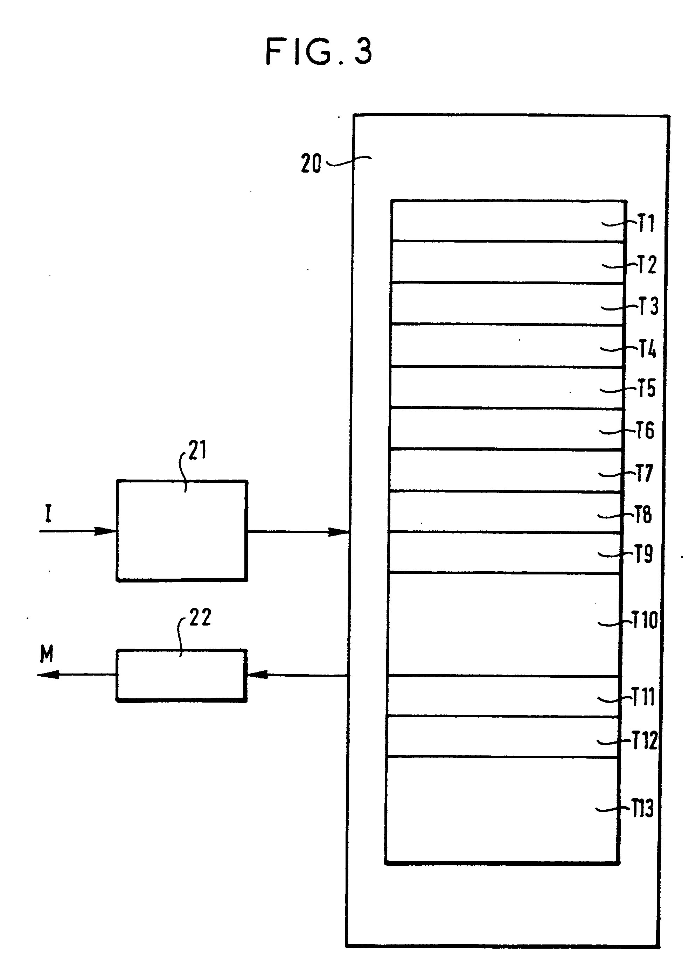

La figure 3 illustre schématiquement un dispositif de décompression correspondant.

Ce dispositif comporte une mémoire notée 20 comportant, dans l'exemple considéré, les zones de données suivantes:
- T1:Table d'adresses de débuts de messages compressés
- T2:Table d'adresses de débuts de mots semi-compressés du premier dictionnaire
- T3:Table d'adresses de débuts de mots semi-compressés du deuxième dictionnaire
- T4:Table d'adresses de débuts de mots semi-compressés du troisième dictionnaire
- T5:Table de tailles de mots semi-compressés du premier dictionnaire
- T6:Table de tailles de mots semi-compressés du deuxième dictionnaire
- T7:Table de tailles de mots semi-compressés du troisième dictionnaire
- T8:premier alphabet
- T9:deuxième alphabet
- T10:zone de messages compressés
- T11:premier dictionnaire
- T12:deuxième dictionnaire
- T13:troisième dictionnaire.

Ce dispositif comporte en outre des moyens, 21, d'adressage de cette mémoire, ces moyens recevant une information d'entrée, notée I, permettant d'identifier le message à décompresser, et ces moyens générant, à partir de cette information d'entrée,les différentes adresses nécessaires au déroulement du procédé de décompression tel que décrit plus haut.

Ce dispositif comporte en outre un registre, 22,destiné à stocker le message décompressé à afficher, noté M, avant transmission à un dispositif d'affichage (non illustré).

L'ensemble formé par les éléments 20, 21, 22 peut être inclus dans un ensemble plus général de traitement de données, notamment un microprocesseur, inclus lui- même dans l'appareil considéré, tel. que notamment un terminal de télécommunications, notamment un téléphone portable.

## Revendications

1. Procédé de compression de messages, notamment de messages destinés à être affichés sur un terminal de télécommunications, notamment un téléphone portable, lesdits messages étant formés de mots formés eux-mêmes de caractères non compressés, comportant la constitution (1, 2) de deux tables de codage, l'une, dite table de codage pour la compression de mots, l'autre, dite table de codage pour la compression de caractères, **caractérisé en ce que**
• la table de codage pour la compression de caractère fait correspondre un caractère compressé représenté par son rang de classement dans cette table, à chaque caractère non compressé,
• la table de codage pour la compression de mots fait correspondre un mot compressé représenté par son rang de classement dans cette table, à chaque mot dit semi-compressé formé d'une séquence de caractères compressés correspondant à ce mot.

2. Procédé selon la revendication 1, **caractérisé en ce que**, ladite table pour la compression de mots comporte elle-même au moins deux tables appelées dictionnaires ayant chacune des capacités de stockage différentes, et **en ce qu'**il comporte en outre un tri (4) des mots constitutifs desdits messages par fréquence d'apparition dans lesdits mots, les mots apparaissant le plus fréquemment étant destinés à être rangés dans un dictionnaire de plus faible capacité.

3. Procédé selon l'une des revendications 1 et 2, **caractérisé en ce que**, ladite table pour la compression de caractères comporte elle-même deux tables appelées alphabets, ayant chacune des capacités de stockage différentes, et **en ce qu'**il comporte en outre un tri (3) des caractéres constitutifs desdits mots par fréquence d'apparition dans lesdits mots, les caractéres apparaissant le plus fréquemment étant destinés à être rangés dans un alphabet de plus faible capacité.

4. Procédé selon l'une des revendications 1 à 3, **caractérisé en ce que** les espaces séparateurs de mots dans lesdits messages sont considérés comme des mots pour la mise en oeuvre de ce procédé.

5. Procédé selon l'une des revendications 1 à 4, **caractérisé en ce que** les messages compressés étant destinés à être stockés de manière contiguë dans une mémoire, et ayant en outre une taille variable, il comporte en outre la constitution (6) d'une table d'adresses de début de messages compressés, destinée à indiquer les adresses de début desdits messages compressés dans ladite mémoire.

6. Procédé selon l'une des revendications 1 à 5, **caractérisé en ce qu'**il comporte en outre une recherche (7) de mots, appelés sous-mots, inclus dans des mots plus longs appelés mots racines, et **en ce que**, seuls les mots racines étant rangés dans ladite table de codage pour la compression de mots, et des rangs de classement dans cette table étant également définis pour ces sous-mots, il est en outre prévu la constitution (8) d'une table d'adresses de début de mots semi-compressés et d'une table de tailles de mots semi-compressés, destinées respectivement à indiquer, pour chaque rang de classement dans ladite table de codage, l'adresse de début, et la taille, du mot semi-compressé correspondant, qu'il s'agisse d'un mot racine ou d'un sous-mot.

7. Procédé de décompression de messages, notamment de messages destinés à être affichés sur un terminal de télécommunications, notamment un téléphone portable, lesdits messages étant formés de mots formés eux-mêmes de caractères non compressés, **caractérisé en ce qu'**il comporte un adressage (13, 14), respectivement par des mots compressés et par des caractères compressés de deux tables de codage, l'une, dite table de codage pour la compression de mots, l'autre, dite table de codage pour la compression de caractères, et **en ce que**
• la table de codage pour la compression de caractère fait correspondre un caractère compressé représenté par son rang de classement dans cette table, à chaque caractère non compressé,
• la table de codage pour la compression de mots fait correspondre un mot compressé représenté par son rang de classement dans cette table, à chaque mot dit semi-compressé formé d'une séquence de caractères compressés correspondant à ce mot.

8. Procédé selon la revendication 7, **caractérisé en ce que** les messages compressés étant stockés de manière contiguë dans une mémoire, et ayant en outre une taille variable, il comporte en outre un adressage (10) d'une table d'adresses de début de messages compressés, destinée à indiquer les adresses de début desdits messages compressés dans ladite mémoire.

9. Procédé selon l'une des revendications 7 et 8, **caractérisé en ce que**, seuls des mots dits mots-racines incluant d'autres mots plus courts appelés sous-mots étant rangés dans ladite table de codage pour la compression de mots, et des rangs de classement dans cette table étant également définis pour ces sous-mots, il comporte en outre un adressage d'une table d'adresses de débuts de mots semi-compressés et d'une table de tailles de mots semi-compressés, destinées respectivement à indiquer, pour chaque rang de classement dans ladite table de codage, l'adresse de début, et la taille, du mot semi-compressé correspondant, qu'il s'agisse d'un mot racine ou d'un sous-mot.

10. Dispositif de décompression de messages, notamment de messages destinés à être affichés sur un terminal de télécommunications, notamment un téléphone portable, lesdits messages étant formés de mots formés eux-mêmes de caractères non compressés, comportant une mémoire (20) contenant deux tables de codage, l'une (T12, T13), dite table de codage pour la compression de mots, l'autre (T8, T9), dite table de codage pour la compression de caractères, **caractérisé en ce que**
• la table de codage pour la compression de caractère fait correspondre un caractère compressé représenté par son rang de classement dans cette table, à chaque caractère non compressé,
• la table de codage pour la compression de mots fait correspondre un mot compressé représenté par son rang de classement dans cette table, à chaque mot dit semi-compressé formé d'une séquence de caractères compressés correspondant à ce mot,
et **en ce qu'**il comporte des moyens d'adressage de ces deux tables, respectivement par des mots compressés et par des caractères compressés.

11. Dispositif selon la revendication 10, **caractérisé en ce que** les messages compressés étant stockés de manière contiguë dans ladite mémoire (20), et ayant en outre une taille variable, ladite mémoire comporte en outre une table (T1) d'adresses de début de messages compressés, destinée à indiquer les adresses de début desdits messages compressés dans cette mémoire, et **en ce que** ce dispositif comporte en outre des moyens (21) d'adressage de cette table d'adresses de débuts de messages compressés.

12. Dispositif selon l'une des revendications 10 et 11, **caractérisé en ce que**, seuls des mots dits mots-racines incluant d'autres mots plus courts appelés sous-mots étant rangés dans ladite table de codage pour la compression de mots, et des rangs de classement dans cette table étant également définis pour ces sous-mots, ladite mémoire (20) comporte en outre une table (T2, T3, T4)d'adresses de débuts de mots semi-compressés et une table (T5, T6, T7) de tailles de mots semi-compressés, destinées respectivement à indiquer, pour chaque rang de classement dans ladite table de codage, l'adresse de début, et la taille, du mot semi-compressé correspondant, qu'il s'agisse d'un mot racine ou d'un sous-mot, et **en ce que** ce dispositif comporte en outre des moyens (21) pour réaliser un adressage de cette table d'adresses de débuts de mots semi-compressés et de cette table de tailles de mots semi-compressés.

## Patentansprüche

1. Verfahren zur Kompression von Nachrichten, insbesondere von Nachrichten. die vorgesehen sind, um auf einem Fernmeldeendgerät, insbesondere einem tragbaren Telefon, angezeigt zu werden, wobei die Nachrichten aus Wörtern gebildet sind, die ihrerseits aus nicht komprimierten Zeichen gebildet sind, welches die Aufstellung (1, 2) von zwei Codiertabellen umfasst, die eine als Codiertabelle für die Kompression von Wörtern, die andere als Codiertabelle für die Kompression von Zeichen bezeichnet, **dadurch gekennzeichnet, dass**
- die Codiertabelle für die Kompression von Zeichen jedem nicht komprimierten Zeichen ein komprimiertes Zeichen zuordnet, das durch seinen Klassierungsrang in der Tabelle dargestellt ist,
- die Codiertabelle für die Kompression von Wörtern jedem sogenannten halbkomprimierten Wort, das aus einer Folge von dem Wort entsprechenden komprimierten Zeichen gebildet ist, ein komprimiertes Wort zuordnet.

2. Verfahren nach Anspruch 1, **dadurch gekennzeichnet, dass** die Tabelle für die Kompression von Wörtern ihrerseits wenigstens zwei als Wörterbücher bezeichnete Tabellen mit jeweils unterschiedlichen Speicherkapazitäten aufweist, und dass es ferner eine Sortierung (4) der die Nachrichten bildenden Wörter nach der Häufigkeit des Auftretens in den Wörtern umfasst, wobei die am häufigsten auftretenden Wörter vorgesehen sind, um in ein Wörterbuch mit geringerer Kapazität eingeordnet zu werden.

3. Verfahren nach einem der Ansprüche 1 und 2, **dadurch gekennzeichnet, dass** die Tabelle für die Kompression von Zeichen ihrerseits zwei als Alphabete bezeichnete Tabellen umfasst, die jeweils unterschiedliche Speicherkapazitäten haben, und dass es ferner eine Sortierung (3) der die Wörter bildenden Zeichen nach der Häufigkeit ihres Auftretens in den Wörtern umfasst, wobei die am häufigsten auftretenden Zeichen vorgesehen sind, um in ein Alphabet mit geringerer Kapazität eingeordnet zu werden.

4. Verfahren nach einem der Ansprüche 1 bis 3, **dadurch gekennzeichnet, dass** die Wortzwischenräume in den Nachrichten für die Durchführung des Verfahrens als Wörter angesehen werden.

5. Verfahren nach einem der Ansprüche 1 bis 4, **dadurch gekennzeichnet, dass**. da die komprimierten Nachrichten vorgesehen sind, um aneinander angrenzend in einem Speicher gespeichert zu werden und außerdem eine variable Größe haben, es außerdem die Aufstellung (6) einer Tabelle von Anfangsadressen von komprimierten Nachrichten umfasst, die vorgesehen ist, um die Anfangsadressen der komprimierten Nachrichten in dem Speicher anzugeben.

6. Verfahren nach einem der Ansprüche 1-5, **dadurch gekennzeichnet, dass** es ferner eine Suche (7) nach Wörtern, als Unterwörter bezeichnet, die in längeren, als Wurzelwörter bezeichneten Wörtern enthalten sind, umfasst, und dass, da nur die Wurzelwörter in die Codiertabelle für die Kompression von Wörtern eingeordnet werden und Klassierungsränge in dieser Tabelle auch für die Unterwörter definiert sind, ferner die Aufstellung (8) einer Tabelle von Anfangsadressen von halbkomprimierten Wörtern und einer Tabelle von Größen von halbkomprimierten Wörtern vorgesehen ist, die jeweils dazu dienen, für jeden Klassierungsrang in der Codiertabelle die Anfangsadresse und die Größe des entsprechenden halbkomprimierten Wortes anzugeben, egal, ob es sich um ein Wurzelwort oder ein Unterwort handelt.

7. Verfahren zur Dekompression von Nachrichten, insbesondere von Nachrichten, die dazu bestimmt sind, auf einem Fernmeldeendgerät, insbesondere einem tragbaren Telefon, angezeigt zu werden, wobei die Nachrichten aus Wörtern gebildet sind, die ihrerseits aus nicht komprimierten Zeichen gebildet sind, **dadurch gekennzeichnet, dass** es eine Adressierung (13, 14), jeweils über komprimierte Wörter und komprimierte Zeichen, von zwei Codiertabellen umfasst, von denen die eine als Codiertabelle für die Kompression von Wörtern und die andere als Codiertabelle für die Kompression von Zeichen bezeichnet ist, und dass
- die Codiertabelle für Kompression von Zeichen jedem nicht komprimierten Zeichen ein komprimiertes Zeichen zuordnet, das durch seinen Klassierungsrang in der Tabelle dargestellt ist,
- die Codiertabelle für die Kompression von Wörtern jedem sogenannten halbkomprimierten Wort, das aus einer Folge von diesem Wort entsprechenden komprimierten Zeichen gebildet ist, ein komprimiertes Wort zuordnet, das durch seinen Klassierungsrang in dieser Tabelle dargestellt ist.

8. Verfahren nach Anspruch 7, **dadurch gekennzeichnet, dass** es, da die komprimierten Nachrichten aneinandergrenzend in einem Speicher gespeichert werden und außerdem eine variable Größe haben, eine Adressierung (10) einer Tabelle von Anfangsadressen von komprimierten Nachrichten umfasst, die dazu dient, die Anfangsadressen der komprimierten Nachrichten in dem Speicher anzugeben.

9. Verfahren nach einem der Ansprüche 7 und 8, **dadurch gekennzeichnet, dass**. da nur sogenannte Wurzelwörter, die andere, kürzere, als Unterwörter bezeichnete Wörter enthalten, in der Codiertabelle für die Kompression von Wörtern eingeordnet sind und Klassierungsränge auch für diese Unterwörter definiert sind, es ferner eine Adressierung einer Tabelle von Anfangsadressen von halbkom-primierten Wörtern und einer Tabelle von Größen von halbkomprimierten Wörtern umfasst, die jeweils dazu dienen, für jeden Klassierungsrang in der Codiertabelle die Anfangsadresse und die Größe des entsprechenden halbkomprimierten Wortes anzugeben, egal ob es sich um ein Wurzelwort oder ein Unterwort handelt.

10. Vorrichtung zur Dekompression von Nachrichten, insbesondere von Nachrichten, die vorgesehen sind, um auf einem Fernmeldeendgerät, insbesondere einem tragbaren Telefon, angezeigt zu werden, wobei die Nachrichten aus Wörtern gebildet sind, die ihrerseits aus nicht komprimierten Zeichen gebildet sind, mit einem Speicher (20). der zwei Codiertabellen enthält, von denen die eine (T12, T13) als Codiertabelle für die Kompression von Wörtern und die andere (T8, T9) als Codiertabelle für die Kompression von Zeichen bezeichnet ist, **dadurch gekennzeichnet, dass**
- die Codiertabelle für die Kompression von Zeichen jedem nicht komprimierten Zeichen ein komprimiertes Zeichen zuordnet, das durch seinen Klassierungsrang in dieser Tabelle dargestellt ist,
- die Codiertabelle für die Kompression von Wörtern jedem sogenannten halbkomprimierten Wort, das aus einer Folge von diesem Wort entsprechenden komprimierten Zeichen gebildet ist, ein komprimiertes Wort zuordnet, das durch seinen Klassierungsrang in dieser Tabelle repräsentiert ist,
und dass sie Mittel zum Adressieren dieser zwei Tabellen jeweils über komprimierte Wörter bzw. komprimierte Zeichen umfasst.

11. Vorrichtung nach Anspruch 10, **dadurch gekennzeichnet, dass**, da die komprimierten Nachrichten aneinandergrenzend in dem Speicher (20) gespeichert sind und außerdem eine variable Größe haben, der Speicher außerdem eine Tabelle (T1) von Anfangsadressen von komprimierten Nachrichten umfasst, die dazu dient, die Anfangsadressen der komprimierten Nachrichten in diesem Speicher anzugeben, und dass die Vorrichtung außerdem, Mittel (21) zum Adressieren dieser Tabelle von Anfangsadressen von komprimierten Nachrichten umfasst.

12. Vorrichtung nach einem der Ansprüche 10 und 11, **dadurch gekennzeichnet, dass**. da nur sogenannte Wurzelwörter, die andere, kürzere, als Unterwörter bezeichnete Wörter enthalten, in die Codiertabelle für die Kompression von Wörtern eingeordnet sind und die Klassierungsränge in dieser Tabelle auch für die Unterwörter definiert sind, der Speicher (20) außerdem eine Tabelle (T2, T3, T4) von Anfangsadressen von halbkomprimierten Wörtern und eine Tabelle (T5, T6, T7) von Größen von halbkomprimierten Wörtern umfasst, die jeweils vorgesehen sind, um für jeden Klassierungsrang in der Codiertabelle die Anfangsadresse und die Größe des entsprechenden halbkomprimierten Worts anzugeben, egal, ob es sich um ein Wurzelwort oder ein Unterwort handelt, und dass die Vorrichtung außerdem Mittel (21) zum Durchführen einer Adressierung dieser Tabelle von Anfangsadressen von halbkomprimierten Wörtern und dieser Tabelle von Größen von halbkomprimierten Wörtern umfasst.

## Claims

1. A method of compressing messages, in particular messages intended to be displayed on a telecommunications terminal, in particular a portable telephone, said messages being made up of words themselves made up of non-compressed characters, said method including compiling (1, 2) two encoding tables, namely an "encoding table for compressing words", and an "encoding table for compressing characters", the method being **characterized in that**:
· the encoding table for compressing characters causes a compressed character represented by its rank in the table to correspond to each non-compressed character; and
· the encoding table for compressing words causes a compressed word represented by its rank in the table to correspond to each "semi-compressed" word made up of a sequence of compressed characters corresponding to the word.

2. A method according to claim 1, **characterized in that**, said encoding table for compressing words itself comprises at least two tables referred to as "dictionaries" and having mutually different storage capacities, and **in that** the method further includes sorting (4) the words making up said messages by frequency of appearance in said messages, the words that appear more frequently being placed in a smaller-capacity dictionary.

3. A method according to claim 1 or 2, **characterized in that**, said encoding table for compressing characters itself comprises two tables referred to as "alphabets" and having mutually different storage capacities, and **in that** the method further includes sorting (3) the characters making up said words by frequency of appearance in said words, the words that appear more frequently being placed in a smaller-capacity alphabet.

4. A method according to any one of claims 1 to 3, **characterized in that** the spaces between words in said messages are considered as words for the purposes of implementing the method.

5. A method according to any one of claims 1 to 4, **characterized in that**, with the compressed messages being intended to be stored contiguously in a memory, and having various sizes, the method further includes compiling (6) a compressed message beginning address table for indicating the addresses of the beginnings of said compressed messages in said memory.

6. A method according to any one of claims 1 to 5, **characterized in that** it further includes searching (7) for words, referred to as "sub-words", included in longer words, referred to as "root words", and **in that**, with only the root words being placed in said encoding table for compressing words, and with ranks in the table also being defined for the sub-words, provision is also made for compiling (8) a semi-compressed word beginning address table and a semi-compressed word size table, these tables serving to indicate, respectively and for each rank in said encoding table, the beginning address and the size of the corresponding semi-compressed word, whether it be a root word or a sub-word.

7. A method of decompressing messages, in particular messages intended to be displayed on a telecommunications terminal, in particular a portable telephone, said messages being made up of words themselves made up of non-compressed characters, said method being **characterized in that** it includes addressing (13, 14) two encoding table respectively with compressed words and with compressed characters, the two encoding tables being respectively an "encoding table for compressing words", and an "encoding table for compressing characters", and **in that**:
· the encoding table for compressing characters causes a compressed character represented by its rank in the table to correspond to each non-compressed character; and
· the encoding table for compressing words causes a compressed word represented by its rank in the table to correspond to each "semi-compressed" word made up of a sequence of compressed characters corresponding to the word.

8. A method according to claim 7, **characterized in that**, with the compressed messages being intended to be stored contiguously in a memory, and having various sizes, the method further includes addressing (10) a compressed message beginning address table for indicating the addresses of the beginnings of said compressed messages in said memory.

9. A method according to claim 7 or 8, **characterized in that**, with only "root" words including other shorter words referred to as "sub-words" being placed in said encoding table for compressing words, and with ranks in the table also being defined for the sub-words, the method further includes addressing a semi-compressed word beginning address table and a semi-compressed word size table, these tables serving to indicate, respectively and for each rank in said encoding table, the beginning address and the size of the corresponding semi-compressed word, whether it be a root word or a sub-word.

10. Apparatus for decompressing messages, in particular messages intended to be displayed on a telecommunications terminal, in particular a portable telephone, said messages being made up of words themselves made up of non-compressed characters, the apparatus including a memory (20) containing two encoding tables, namely an "encoding table for compressing words" and an "encoding table for compressing characters" (T8, T9), the apparatus being **characterized in that**:
· the encoding table for compressing characters causes a compressed character represented by its rank in the table to correspond to each non-compressed character; and
· the encoding table for compressing words causes a compressed word represented by its rank in the table to correspond to each "semi-compressed" word made up of a sequence of compressed characters corresponding to the word,
and **in that** it includes means for addressing the two tables, respectively with compressed words and with compressed characters.

11. Apparatus according to claim 10, **characterized in that**, with the compressed messages being stored contiguously in said memory (20), and having various sizes, said memory further includes a compressed message beginning address table (T1) for indicating the addresses of the beginnings of said compressed messages in said memory, and **in that** the apparatus further includes means (21) for addressing the compressed message beginning address table.

12. Apparatus according to claim 10 or 11, **characterized in that**, with only "root" words including other shorter words referred to as "sub-words" being placed in said encoding table for compressing words, and with ranks in the table also being defined for the sub-words, said memory (20) further includes a semi-compressed word beginning address table (T2, T3, T4) and a semi-compressed word size table (T5, T6, T7), these tables serving to indicate, respectively and for each rank in said encoding table, the beginning address and the size of the corresponding semi-compressed word, whether it be a root word or a sub-word, and **in that** the apparatus further includes means (21) for addressing the semi-compressed word beginning address table and the semi-compressed word size table.
